# EUROPÄISCHE PATENTSCHRIFT

(11) **EP 2 923 836 B1**
(45) Veröffentlichungstag und Bekanntmachung des Hinweises auf die Patenterteilung: **25.11.2020**
(21) Anmeldenummer: 15160433.7
(22) Anmeldetag: 24.03.2015
(51) Int. Cl.: B41C 1/14, B41N 1/24, H05K 3/12

(54) **VERFAHREN ZUR HERSTELLUNG EINER DRUCKSCHABLONE FÜR DEN TECHNISCHEN DRUCK**
METHOD FOR MANUFACTURING A PRINTING STENCIL FOR TECHNICAL PRINTING
PROCÉDÉ DE PRODUCTION D'UN POCHOIR POUR L'IMPRESSION TECHNIQUE

(30) Priorität: 25.03.2014 DE 102014205547
(43) Veröffentlichungstag der Anmeldung: 30.09.2015
(73) Patentinhaber: Christian Koenen GmbH, 85521 Ottobrunn (DE)
(72) Erfinder: Koenen, Christian, 85521 Ottobrunn-Riemerling (DE)
(74) Vertreter: MERH-IP Matias Erny Reichl Hoffmann Patentanwälte PartG mbB

(56) Entgegenhaltungen:
- DE-A1-102005 016 027
- JP-A- H0 639 988
- JP-A- 2009 208 259

## Beschreibung

Die Erfindung betrifft ein Verfahren zur Herstellung einer Druckschablone für den technischen Druck und eine entsprechende Druckschablone für den technischen Druck, insbesondere den technischen Leiterplatten-Druck bei dem im Druckverfahren mittels einer Schablone Lotpaste in sog. Pads auf eine Leiterplatte gedruckt wird.

Insbesondere betrifft die vorliegende Erfindung ein Verfahren zum Herstellen einer Druckschablone bzw. einer Präzisionsschablone für den technischen Druck mit den Verfahrensschritten Aufspannen einer ggf. aus einem dünnwandigen Rohblech auf eine vorgegebene Schablonengröße zugeschnittenen Rohschablone auf einer ebenen Tragplatte eines Aufspanntisches mit Ansaugöffnungen oder einer ebenen Tragplatte aus porösem Stein zum ebenen Ansaugen der Rohschablone durch Unterdruck bzw. Vakuum, und Ausschneiden von einer Mehrzahl von Pad-Öffnungen aus der Druckschablone in vorgegebener genauer Positionierung, Größe und Form mittels eines Laserstrahls, d.h. durch sogenanntes Laserschneiden.

### Hintergrund der Erfindung

Dem Stand der Technik ist es bekannt, derartige Druckschablonen bzw. Präzisionsschablonen bei der sogenannten SMT-Technik (SMT engl. für "surface mounting technology") zu verwenden, um Leiterplatten mit unterschiedlichen elektronischen Bauelementen unterschiedlichster Art und Größe zu bestücken, bzw. unterschiedliche elektronische Bauelemente unterschiedlichster Art und Größe auf einer Leiterplatte bzw. einem Substrat aufzubringen. Derartige Leiterplatten sind im Stand der Technik unter der Bezeichnung SMD-Platinen bzw. SMD-Leiterplatten bekannt (SMD engl. für "surface mounted device"). Gedruckt werden mit einer Schablone auch Silberleitpasten u. a. auch auf Keramiken, Wärmeleitpasten (Abführen der im Bauteil entstehenden Wärme auf eine Kupferlage in oder an der Leiterplatte, Klebstoffe etc.

Hierbei ist es nach dem Stand der Technik bekannt, mittels eines technischen Druckverfahrens eine sogenannte Lotpaste auf die Leiterplatte bzw. das Substrat aufzubringen, wobei die Lotpaste in Bereichen, die für eine Bestückung durch elektronische Bauelemente vorgesehen sind, auf die Leiterplatte aufgebracht wird, indem auf der Rakelseite der Druckschablone eine Rakel über die Druckschablone gestrichen wird, um Lotpaste im technischen Druckverfahren durch die Pad-Öffnungen der Druckschablone zu drücken bzw. auf die Leiterplatte zu drucken.

Die Pad-Öffnungen werden hierbei bei Herstellung der Druckschablonen in Abhängigkeit einer individuellen vorgesehenen Leiterplattenarchitektur, d.h. in Abhängigkeit der individuellen vorgesehenen Positionierungen der aufzubringenden elektronischen Bauelemente, in genauer Positionierung, Größe und Form ausgeschnitten, bzw. herausgearbeitet.

Im Herstellungsverfahren von derartigen SMD-Leiterplatten haben sich heutzutage lasergeschnittene Metallschablonen für den technischen Druck durchgesetzt, bei denen die vorstehend beschriebenen Pad-Öffnungen in der Druckschablone mittels eines Laserstrahls ausgeschnitten bzw. herausgearbeitet werden, d.h. durch Laserschneiden. Somit wird ermöglicht, eine hohe Präzision bei dem Zuschneiden bzw. Herausarbeiten der Pad-Öffnungen bezüglich der vorgegebenen Positionierung, Größe und Form der Pad-Öffnungen zu erreichen.

Des Weiteren sind dem Stand der Technik für derartige Druckschablonen unterschiedliche Einspannsysteme bekannt. Einerseits ist es z.B. bekannt, Druckschablonen auf einem in einen Rahmen eingespannten, feinmaschigen Druckgewebe permanent aufzukleben, aufzuschweißen bzw. anderweitig zu befestigen, wobei in einem mittigen Bereich des Druckgewebes ein Ausschnitt vorgesehen ist, in dem die eigentliche Druckschablone vorgesehen ist.

Andererseits sind dem Stand der Technik Einspannsysteme für Druckschablonen für den technischen Druck bekannt, bei denen die Druckschablone an zumindest zwei gegenüberliegenden Rändern einen sogenannten Lochrand bzw. Einspannöffnungen aufweist, wobei die Druckschablone mittels der Löcher bzw. Einspannöffnungen des Lochrands der Druckschablone direkt in ein Einspannsystem oder einen formsteifen Rahmen eingespannt werden kann.

Des Weiteren sind nach dem Stand der Technik für das technische Druckverfahren bei der Herstellung von SMD-Leiterplatten, bei denen es vorgesehen ist, elektrische Bauelemente unterschiedlichster Art, Größen und Formen auf die Leiterplatte aufzubringen, d.h. bei einer sogenannten Mischbestückung der Leiterplatte, sogenannte Stufenschablonen bekannt, bei denen im vorstehend beschriebenen Herstellungsverfahren der Druckschablonen zusätzlich zu den Pad-Öffnungen Stufen, Einsenkungen bzw. Vertiefungen unterschiedlicher Form und Größe in Bereichen vorgesehen sind, die die Pad-Öffnungen umgeben, um sogenannte Pastendepots bzw. Lotpastendepots für die Lotpaste mit unterschiedlichen Höhen zu ermöglichen.

Derartige Lotpastendepots werden in den Pad-Öffnungen gebildet und ein in den Lotpastendepots aufnehmbares Lotpastenvolumen ergibt sich im Wesentlichen durch die Größe einer entsprechenden Pad-Öffnung und der Tiefe der Druckschablone in dem die entsprechende Pad-Öffnung umgebenden Bereich der Druckschablone. Beim Aufbringen der Lotpaste auf die Leiterplatte mittels derartiger Stufenschablonen ist es somit möglich, in Abhängigkeit des Volumens der Lotpastendepots die Lotpastenmenge bzw. die aufgebrachten Lotpastenvolumina an die Anforderungen der jeweiligen aufzubringenden Bauelemente anzupassen. Somit ist das Aufbringen unterschiedlicher Lotpastenvolumina bei Mischbestückung einer Leiterplatte in einem Arbeitsschritt mittels einer dafür vorgesehenen Druckschablone möglich.

Zur Herstellung derartiger Stufenschablonen ist es dem Stand der Technik z.B. bekannt, zum Herausarbeiten der Vertiefungen auf der Stufenschablone Ätztechniken anzuwenden, um vorbestimmte Bereiche innerhalb der Schablone abzutragen. Des Weiteren ist es bekannt, derartige Vertiefungen durch galvanischen Aufbau der Schablone oder das sogenannte Senkerodieren herauszuarbeiten. Jedoch ist die erreichbare Genauigkeit bezüglich der Positionierung, Größe und Form der Vertiefungen auf der Stufenschablone in derartigen Verfahren unvorteilhaft gering. So ist es in derartigen Verfahren z.B. nicht möglich, eine heutzutage erforderliche genaue Präzision von wenigen µm bezüglich der Positionierung, Größe, Tiefe und Form der Vertiefungen bzw. Stufen der Druckschablone zu erreichen.

Außerdem muss bei dem Verfahren mittels Senkerodieren für jede Vertiefung im Schablonenblech eine gesonderte Elektrode gefertigt werden. Ferner treten hohe Wärmebelastungen in den funkenerosiv abzutragenden Bereichen auf, wodurch unerwünschte Blaufärbungen in den Bereichen der Vertiefungen und umgebenden Bereichen auf der Stufenschablone entstehen.

In der DE 297 08 329 U1 wurde ohne nähere Angaben zu technischen Einzelheiten angegeben, dass Metallschablonen für den technischen Druck derart bearbeitet werden, dass auf der Leiterplattenseite mittels fräsen oder ätzen Dickenreduzierungen eingearbeitet werden, um zu ermöglichen, dass die Druckschablone bei geringer Verformung in dem Druckprozess auf der Leiterplatte aufliegt. Insbesondere ist es nach der Lehre der DE 297 08 329 U1 vorgesehen, eine Druckschablone aus mehreren übereinanderliegenden Folienlagen unterschiedlicher Materialien mit unterschiedlichen Elastizitätsmodulen zu fertigen. Jedoch sind Druckschablonen bestehend aus verschiedenen Materialien auf Dauer nicht haltbar und insbesondere verschleißempfindlich, d.h. derartige Stufenschablonen sind ggf. nur für eine niedrige Anzahl von Druckvorgängen geeignet.

Aus der DE 10 2005 016 027 A1 ist ein Herstellungsverfahren für den technischen Druck bekannt, bei dem Einsenkungen auf einer Seite eines Rohblechs durch Hochgeschwindigkeitsfräsen bei Umdrehungen des Fräswerkzeugs größer 20.000 min⁻¹, insbesondere bis 100.000 min⁻¹ herausgearbeitet werden. Jedoch tritt bei diesem Verfahren das Problem auf, dass eine Oberfläche der herausgearbeiteten Einsenkungen einen sehr niedrigen Rauheitswert deutlich unter 0.5 µm aufweist. Wird nun im technischen Druckverfahren Lotpaste mittels einer Rakel auf der Rakelseite während des sogenannten Rakelns verstrichen, so wird die Lotpaste aufgrund der sehr niedrigen Rauheitswerte der Oberfläche vor der Rakel entlang der Oberfläche der Vertiefungen geschoben.

Hierbei tritt das Problem auf, dass die Lotpaste nicht gleichmäßig in die Pad-Öffnungen gelangt bzw. nur ein Teil der Pad-Öffnungen bzw. Lotpastendepots mit Lotpaste ausgefüllt wird, so dass das Aufbringen der Lotpaste an einzelnen Pads ungleichmäßig erfolgt, wodurch außerdem eine unvorteilhafte Ungenauigkeit bezüglich des vorgesehenen Lotpastenvolumens auftritt, so dass die Lotpaste ggf. mit einem von dem vorgesehenen Lotpastenvolumen abweichenden Lotpastenvolumen auf die Leiterplatte aufgebracht wird. Dies ist für die darauffolgende Bestückung der Leiterplatte mit elektrischen Bauelementen unvorteilhaft und kann sogar dazu führen, dass einzelne Bauelemente unpräzise oder in von den Vorgaben abweichender Positionierung und/oder Lage auf der Leiterplatte befestigt werden, so dass ggf. die gesamte Leiterplatte unbrauchbar ist und neu hergestellt werden muss.

Des Weiteren können diese hohen Drehzahlen dazu führen, dass das Fräswerkzeug einen zu hohen bzw. zu schnell auftretenden Verschleiß aufweist. Hierbei kann bei dem Fräsen der Einsenkungen durch die einseitige zerspanende Materialabtragung aus dem eben gespannten Druckschablonenblech eine Verspannung im Material des Schablonenblechs auftreten, die zu einer unerwünschten Welligkeit des späteren Schablonenblechs führt. Derartige Verspannungen im Schablonenblech treten insbesondere bei dem Herausarbeiten tiefer Einsenkungen auf. Bei dem Auftreten derartiger Verspannungen kann die entstehende Welligkeit nicht wieder ausgeglichen werden und die Druckschablone ist nicht verwendbar und muss daher neu aus einem neuen Rohblech gefertigt werden, wodurch nachteilig höhere Ausschusszahlen auftreten.

### Zusammenfassung der Erfindung

Eine Aufgabe der vorliegenden Erfindung ist es, die vorstehend beschriebenen Probleme des Stands der Technik zu vermeiden, und ein Verfahren zum Herstellen einer Druckschablone für den technischen Druck und eine entsprechende Druckschablone für den technischen Druck bereitzustellen, derart, dass ein Herausarbeiten von Vertiefungen auf der Druckschablone bei hoher Genauigkeit und Flexibilität bezüglich der Größe, Tiefe, Form und Positionierung der Vertiefungen ermöglicht ist, und die Druckschablone des Weiteren ein präzises gleichmäßiges Druckverhalten beim Aufbringen der Lotpaste mittels der Rakel aufweist, insbesondere mit präzise aufgebrachten Lotpastenvolumina. Eine weitere Aufgabe der vorliegenden Erfindung ist es, die vorstehend beschriebenen Probleme des Stands der Technik zu vermeiden, und ein Verfahren zum Herstellen einer Druckschablone für den technischen Druck und eine entsprechende Druckschablone für den technischen Druck bereitzustellen, derart, dass ein Herausarbeiten von Vertiefungen auf der Druckschablone bei hoher Genauigkeit und Flexibilität bezüglich der Größe, Tiefe, Form und Positionierung der Vertiefungen ermöglicht ist, wobei eine gewünschte Ebenheit der Druckschablone erreicht werden kann.

Die vorstehend beschriebenen Aufgaben der vorliegenden Erfindung werden gelöst durch ein Verfahren zum Herstellen einer Druckschablone für den technischen Druck nach Anspruch 1. Bevorzugte Ausführungsbeispiele der vorliegenden Erfindung werden durch die Merkmale der abhängigen Ansprüchen beschrieben.

Das erfindungsgemäße Verfahren zum Herstellen einer Druckschablone für den technischen Druck umfasst die Verfahrensschritte Aufspannen einer Rohschablone auf einer ebenen Tragplatte mit Ansaugöffnungen oder einer ebenen Tragplatte aus einem porösen Material ggf. aus porösem Stein oder Metall zum ebenen Ansaugen der Rohschablone durch Unterdruck, und Ausschneiden von einer Mehrzahl von Pad-Öffnungen aus der Druckschablone in vorgegebener genauer Positionierung, Größe und Form mittels eines Laserstrahls.

Des Weiteren ist das erfindungsgemäße Verfahren zum Herstellen einer Druckschablone für den technischen Druck gekennzeichnet durch den weiteren Verfahrensschritt Herausarbeiten von einer oder mehrerer ebenen Vertiefungen in vorgegebener Positionierung, Form, Größe und/oder Tiefe aus der aufgespannten Druckschablone auf mindestens einer Seite der Druckschablone durch Fräsen mittels eines Fräswerkzeugs bei Drehzahlen im Wesentlichen unter 10.000 min⁻¹, wobei die Oberfläche der durch Fräsen herausgearbeiteten Vertiefungen eine Oberflächenrauheit mit einem Rauheitswert Ra im Wesentlichen im Bereich größer oder gleich 1 µm bis zu 12,5 µm aufweist.

Im erfindungsgemäßen Verfahrensschritt des Herausarbeitens der einen oder mehreren Vertiefungen durch Fräsen bei Drehzahlen unter 10.000 min⁻¹ kann durch die präzise Vorschubsteuerung des Fräswerkzeugs eine Positionierung, Form, Größe und/oder Tiefe der einen oder mehreren Vertiefungen bei sehr hoher Präzision mit einer Genauigkeit bis zu unter einem 1 µm herausgearbeitet werden, so dass eine Genauigkeit entsprechend der heutigen Erfordernisse in der SMT-Technik erreicht werden kann.

Des Weiteren ist es vorteilhaft möglich, Vertiefungen mit unterschiedlichen Tiefen auf einer Druckschablone mit einer jeweiligen hohen Präzision bezüglich der Tiefe der Vertiefungen herauszuarbeiten, so dass auf einer Druckschablone Lotpastendepots unterschiedlichster Lotpastenvolumina von mehreren mm³ bis wenigen µm³ herausgearbeitet werden können, die mit nur einer Rakelbewegung auf eine Leiterplatte aufgebracht werden können.

Insbesondere können die jeweiligen Lotpastendepots unabhängig von der Größe der Pad-Öffnungen angepasst werden. Durch die hohe erreichbare Präzision des Fräsverfahrens bei Drehzahlen unter etwa 25.000 min⁻¹ und insbesondere unter 10.000 min⁻¹ können die Lotpastendepots insbesondere präzise entsprechend den vorgegebenen Lotpastenvolumina ausgebildet werden, mit Genauigkeiten bis unter 1 µm³ Abweichung vom Sollwert.

Des Weiteren kann die Oberfläche der Vertiefungen bei der Herstellung der Druckschablone bedingt durch die Wahl der vergleichsweise niedrigen, insbesondere im Wesentlichen unter 25.000 min⁻¹ und insbesondere unter 10.000 min⁻¹ liegenden Drehzahlen des Fräswerkzeugs mit höheren Rauheitswerten herausgearbeitet werden.

Im Gegensatz hierzu treten beim Fräsen mit höheren Drehzahlen, insbesondere bei einem Hochgeschwindigkeitsfräsen mit Drehzahlen über 30.000 min⁻¹ bis zu 100.000 min⁻¹ unvorteilhaft niedrige Rauheitswerte der Oberfläche auf, bei der das vorstehend beschriebene Problem auftritt, dass die Lotpaste beim Rakeln auf der glatten Oberfläche vor dem Rakel geschoben wird und somit während des Druckprozesses unvorteilhaft ungleichmäßig in die Pad-Öffnungen eingebracht wird.

Die hohen Rauheitswerte Ra der Oberfläche der Vertiefungen von größer oder gleich 0.5 µm, vorzugsweise im Wesentlichen größer oder gleich 1 µm, bieten jedoch den Vorteil, dass die Lotpaste beim Rakeln vor dem Rakel auf der Oberfläche der Vertiefungen rollt bzw. abrollt und somit vollständig und gleichmäßig in die Pad-Öffnungen eingebracht werden kann, wodurch ein verbessertes Druckbild auf der Leiterplatte aufgebracht werden kann.

Speziell ist es somit möglich, das Lotpastenvolumen genau anzupassen, da das tatsächliche Lotpastenvolumen genau an dem Volumen der Lotpastendepots orientiert ist, wenn das Lotpastendepot beim Rakeln vollständig und gleichmäßig mit Lotpaste gefüllt wird.

Durch die niedrige Wahl der Drehzahlen im Wesentlichen unter 25.000 min⁻¹ und insbesondere unter 10.000 min⁻¹ ergibt sich weiterhin der unerwartete Vorteil, dass Verspannungen im Druckschablonenblech selbst bei dem Herausarbeiten tiefer Vertiefungen mit bis zu einer Reststärke von etwa 10 µm der Druckschablone gefräst werden können, wobei dennoch niedrigere Ausschussraten erreicht werden können, da im Gegensatz zum Hochgeschwindigkeitsfräsen bei Drehzahlen oberhalb von 30.000 min⁻¹ lediglich geringe oder keine Verspannungen in der Druckschablone erzeugt werden, so dass es nach dem Ausspannen des Blechs von der Tragplatte zu keinen unerwünschten Verzerrungen bzw. Aufwellungen des Druckschablonenblechs kommt.

Vorzugsweise wird die zu erreichende Oberflächenrauheit bzw. der zu erreichende Oberflächenrauheitswert in Abhängigkeit der Größe der Oberfläche der Vertiefung und/oder in Abhängigkeit eines Volumens der Vertiefung vorgegeben. Hierfür haben sich insbesondere Vertiefungen mit einer Oberflächenrauheit entsprechend eines Rauheitswerts Ra im Wesentlichen im Bereich von größer oder gleich 0,5 µm bis 12,5 µm als vorteilhaft erwiesen. Vorzugsweise weisen die Vertiefungen hierbei insbesondere eine Oberflächenrauheit von Ra im Wesentlichen grösser oder gleich 1 µm auf.

Vorzugsweise kann das Verfahren den noch den weiteren Verfahrensschritt des Nachbearbeitens der Oberfläche der durch Fräsen herausgearbeiteten Vertiefungen zum Erhöhen der Oberflächenrauheit umfassen, so dass die Oberfläche der durch Fräsen herausgearbeiteten Vertiefungen nach dem Nachbearbeiten eine Oberflächenrauheit im Wesentlichen mit einem Rauheitswert Ra von 0,5 µm, vorzugsweise im Wesentlichen größer oder gleich 1 µm, bis etwa 12,5 µm aufweist. Dies ermöglicht es durch Nachbearbeitung der Oberfläche eine noch vorteilhaft rauere Oberfläche herauszuarbeiten, um ein weiterhin verbessertes Abrollverhalten der Lotpaste zu ermöglichen.

Hierbei kann der Schritt des Nachbearbeitens der Oberfläche der durch Fräsen herausgearbeiteten Vertiefungen vorzugsweise durch Schleifen und/oder Bürsten der Oberfläche ausgeführt werden.

Vorzugsweise wird im Schritt Herausarbeiten einer oder mehrerer der einen oder mehreren Vertiefungen durch Fräsen für die Drehzahl des Fräswerkzeugs ein vorgegebener Wert vorzugsweise im Wesentlichen größer oder gleich 2.000 min⁻¹ und/oder im Wesentlichen kleiner oder gleich 10.000 min⁻¹ vorzugsweise im Wesentlichen im Bereich zwischen etwa 2.000 min⁻¹ und etwa 10.000 min⁻¹ gewählt, noch vorteilhafter im Wesentlichen kleiner oder gleich 6.000 min⁻¹. Bei diesen niedrigen Drehzahlen des Fräswerkzeugs sind besonders vorteilhafte Rauheitswerte der Oberfläche der einen oder mehreren Vertiefungen bei gleichzeitiger vorteilhafter Ebenheit der Oberfläche der Vertiefungen erreichbar, insbesondere ggf. sogar ohne eine weitere erforderliche Nachbearbeitung der Oberfläche z.B. durch schleifende und/oder bürstende Nachbearbeitung. Des Weiteren hat sich der Drehzahlbereich zwischen 2.000 min⁻¹ und 10.000 min⁻¹ und insbesondere zwischen 2.000 min⁻¹ und 6.000 min⁻¹ als äußerst vorteilhaft erwiesen, da in diesem Bereich im Druckschablonenblech auftretende Verspannungen weiter reduziert werden können, selbst bei tiefen Vertiefungen mit Reststärken der Druckschablone bis zu etwa 10µm Reststärke.

Vorzugsweise ist die Rohschablone eine dünnwandige Rohschablone aus Edelstahl. Vorzugsweise ist die eingespannte Rohschablone hierbei eine aus einem dünnwandigen Rohblech auf eine vorgegebene Schablonengröße zugeschnittene Rohschablone, wobei das erfindungsgemäße Verfahren ggf. einen weiteren Verfahrensschritt des Zuschneidens eines vorzugsweise dünnwandigen Rohblechs auf die vorgegebene Schablonengröße und/oder Schablonenform umfasst, ggf. in Abhängigkeit eines Einspannsystems für die Druckschablone.

Dies bietet den Vorteil, dass bei der Herstellung der Druckschablone auf Rohbleche mit unterschiedlichen Blechdicken zurückgegriffen werden kann, so dass erfindungsgemäß Druckschablonen mit unterschiedlichsten Schablonentiefen gefertigt werden können. Diese weisen vorteilhaft eine hohe Zugfestigkeit, Stabilität und Ebenheit auf und sind bezüglich des Rakelns mittels des Rakels im Druckprozess auf der Rakelseite vorteilhaft unempfindlich und weisen einen stark verringerten Verschleiß auf. Des Weiteren sind derartige Rohschablonen in vielfältigen Geometrien und Formen herstellbar und weisen einen vorteilhaft niedrigen Temperaturausdehnungskoeffizienten auf.

Vorzugsweise werden eine oder mehrere der einen oder mehreren Vertiefungen derart herausgearbeitet, dass die Druckschablone in einer oder mehreren Vertiefungen eine Reststärke im Wesentlichen größer oder gleich 10 µm aufweist.

Dies bietet den Vorteil, dass eine für den Druckprozess erforderliche Stabilität der Druckschablone ermöglicht ist, wobei Vertiefungen bis zu sehr niedrigen Reststärken etwa im Wesentlichen bis zu 10 µm der Druckschablone herausgearbeitet werden können. Außerdem können bei den geringen Reststärken der Druckschablone bis etwa 10 µm bei kleinen Pad-Öffnungen kleinste Lotpastendepots bei gleichzeitiger hoher Präzision bezüglich des Lotpastenvolumens ausgebildet werden.

Vorzugsweise weist die Rohschablone des Weiteren eine Schablonenstärke von etwa 20 µm bis 1000 µm auf. Somit sind Druckschablonen unterschiedlichster Schablonenstärken zwischen etwa 20 µm bis 1000 µm möglich. Jedoch sind vorrätig gehaltene Rohschablonen oftmals nur in bestimmten Schablonenstärken verfügbar. Hierbei umfasst das erfindungsgemäße Verfahren vorzugsweise den weiteren Verfahrensschritt des Abtragens einer Schicht der Rohschablone über den gesamten Bereich der Rohschablone, um eine Druckschablone mit einer Schablonenstärke zu fertigen, die von der Schablonenstärke der Rohschablone abweicht. Somit ist es insbesondere vorteilhaft möglich, Druckschablonen mit Schablonenstärken herzustellen, selbst, wenn mit dieser Schablonenstärke keine Rohschablone vorrätig ist oder nicht verfügbar ist.

Vorzugsweise werden die eine oder mehreren Vertiefungen derart durch Fräsen herausgearbeitet, dass ein oder mehrere Ränder der einen oder mehreren Vertiefungen als eine oder mehrere Stufen ausgebildet werden. Hierbei bietet sich der Vorteil, dass das Rakel während des Rakelns vorteilhaft auf dem in Stufen ausgebildeten Rand einer oder mehrerer Vertiefungen vorteilhaft auf- und/oder abklettern kann.

Vorzugsweise werden die eine oder mehreren Vertiefungen derart durch Fräsen herausgearbeitet, dass ein oder mehrere Ränder der einen oder mehreren Vertiefungen rampenförmig ausgebildet sind. Dies kann gegebenenfalls bei dem Schritt des Herausarbeitens der einen oder mehreren Vertiefungen durch Fräsen einer Mehrzahl von tribünenartig angeordneten Stufen an zumindest einem Rand einer Vertiefung erreicht werden. Hierbei bietet sich der Vorteil, dass das Rakel während des Rakelns vorteilhaft auf dem rampenförmig ausgebildeten Rand einer oder mehrerer Vertiefungen vorteilhaft auf- und/oder abklettern kann.

Vorzugsweise ist das Fräswerkzeug ein Stirnfräser und vorzugsweise wird die Drehzahl des Fräswerkzeugs an der Umfangsgeschwindigkeit des Fräswerkzeugs orientiert und vorzugsweise in Abhängigkeit des Durchmessers des Fräswerkzeugs gewählt.

Dies hat den Vorteil, dass eine Schneidgeschwindigkeit an der Umfangfläche des Fräswerkzeugs, insbesondere eines Stirnfräsers, bzw. die Schneidgeschwindigkeit an der Schneidenaußenseite des Fräswerkzeugs, insbesondere eines Stirnfräsers, beim Fräsen vorteilhaft eingestellt werden kann, indem die Drehzahl des Fräswerkzeugs an dem Durchmesser orientiert gewählt wird.

Vorzugsweise weist die Rohschablone einen Härtegrad im Wesentlichen kleiner oder gleich 560HV auf.

Vorzugsweise ist der Abstand zwischen Rändern von zwei nebeneinander liegenden, herausgearbeiteten Vertiefungen im Wesentlichen größer oder gleich 5 µm.

Somit kann gewährleistet werden, dass Stegstärken zwischen zwei nebeneinander liegenden Vertiefungen eine ausreichende Stabilität aufweisen und auch selbst auf der Rakelseite beim Rakeln verschleißunempfindlich sind und nicht beschädigt werden. Dennoch ist es durch die präzise Bearbeitung mittels Fräsen möglich, Vertiefungen bis zu einem Abstand von 5 µm nebeneinander auf der Druckschablone herauszuarbeiten, wodurch eine vorteilhaft hohe Flexibilität bezüglich der möglichen Druckschablonen und Druckmuster ermöglicht ist.

Vorzugsweise werden die eine oder mehreren Vertiefungen zumindest auf der Rakelseite der Druckschablone herausgearbeitet. Dies bietet den Vorteil, dass die bei dem Fräsen erreichte Oberflächenrauheit der auf der Rakelseite gefrästen Oberflächen bei Drehzahlen unter 25.000 min⁻¹ und insbesondere unter 10.000 min⁻¹ zu einem vorteilhaften Abrollen bzw. Rollen der Lotpaste beim Rakeln entlang der Oberfläche der Vertiefungen auf der Rakelseite führt, so dass die Lotpaste vorteilhaft gleichmäßig und ausfüllend in die Pad-Öffnungen bzw. Lotpastendepots eingebracht werden kann.

Vorzugsweise weisen die eine oder mehreren durch Fräsen herausgearbeiteten Vertiefungen auf der Rakelseite der Druckschablone eine Tiefe in Abhängigkeit eines vorbestimmten Lotpastenvolumens zumindest einer der Mehrzahl von Pad-Öffnungen in der Vertiefung auf. Somit können vorteilhaft Vertiefungen mit unterschiedlichen Tiefen herausgearbeitet werden, um unterschiedlich hohe Lotpastendepots in der Druckschablone zu ermöglichen, insbesondere ggf. unabhängig von der Größe der Pad-Öffnungen, so dass das Aufbringen unterschiedlicher Lotpastenvolumina z.B. für eine Mischbestückung einer Leiterplatte in einem Arbeitsschritt mittels der gleichen Druckschablone und insbesondere mittels einer einzigen Rakelbewegung in einem Druckvorgang auf die Leiterplatte möglich ist.
Vorzugsweise umfasst das Verfahren weiterhin den Schritt des Glättens einer Innenwandung zumindest einer der Mehrzahl von Pad-Öffnungen, wobei das Glätten einer Innenwandung einer Pad-Öffnung mittels eines elektrochemischen Abtragungsverfahrens durchgeführt wird, insbesondere mittels eines elektrochemischen Polierverfahrens, ggf. durch das sog. Elektropolieren. Dies hat den Vorteil, dass die Lotpaste auf die Leiterplatte aufgebracht werden kann, ohne dass Lotpastenreste in der Pad-Öffnung an der Innenwandung haften, wenn die Druckschablone von der Leiterplatte nach dem Druckvorgang entfernt wird. Somit kann das Lotpastenvolumen besonders präzise durch Größe und Tiefe der Pad-Öffnungen bestimmt werden. Des Weiteren ist es vorteilhaft nicht erforderlich, die Druckschablone zwischen Druckvorgängen von Lotpastenresten zu reinigen.

Vorzugsweise werden die eine oder mehreren Vertiefungen zumindest auf der Leiterplattenseite der Druckschablone herausgearbeitet, wobei die eine oder mehreren Vertiefungen auf der Leiterplattenseite vorzugsweise in Abhängigkeit einer Positionierung, Größe, Höhe und/oder Form von Durchkontaktierungen bzw. Erhebungen durch Kontakte oder schon aufgebrachte Bauelemente auf der Leiterplatte herausgearbeitet. Dies hat den Vorteil, dass die Druckschablone für den Druckprozess eben auf die Leiterplatte eben aufliegen kann, selbst wenn bereits Durchkontaktierungen, Kontakte und/oder Bauelemente in bestimmten Bereichen der Leiterplatte aufgebracht sind.

Vorzugsweise weist die Oberfläche der einen oder mehreren Vertiefungen regelmäßige Frässpuren auf. Die regelmäßigen Frässpuren ermöglichen es, dass die Lotpaste während des Rakelns besonders vorteilhaft vor der Rakel auf der Oberfläche der Vertiefungen rollt bzw. abrollt. Jedoch ist es hierbei nicht erforderlich, dass die Oberfläche der Vertiefungen gleichmäßige Frässpuren, also z.B. mit konstanter Frässpurenbreite aufweist.

Vorzugsweise wird das Fräswerkzeug mit Vorschub bei einem Überdeckungsgrad der Frässpuren im Wesentlichen von bis zu 90% betrieben. Somit können vorteilhafte Rauheitswerte der Oberfläche der Vertiefungen erzielt werden, ohne das Erfordernis einer weiteren Nachbearbeitung der Oberfläche.

Vorzugsweise weist die Oberfläche der herausgearbeiteten Vertiefungen eine Ebenheit im Wesentlichen kleiner oder gleich 40 µm auf, vorzugsweise im Wesentlichen kleiner oder gleich 20 µm, insbesondere vorteilhaft vorzugsweise im Wesentlichen kleiner oder gleich 10 µm. Oberflächen mit derartigen Ebenheitswerten weisen ein insbesondere vorteilhaftes Rakelverhalten auf. Die Rakel liegt hierbei mit hoher Genauigkeit entlang der gesamten Länge der Rakel auf der Oberfläche auf, und die Lotpaste kann bei der Rakelbewegung vorteilhaft entlang der gesamten Länge der Rakel vor der Rakel rollen bzw. abrollen.

Vorzugsweise weist der Aufspanntisch bzw. die Platte aus ggf. porösem Stein eine Ebenheit mit einem Welligkeitswert im Wesentlichen unter 5 µm auf, insbesondere vorteilhaft vorzugsweise im Wesentlichen unter 1 µm. Vorzugsweise weisen die Ansaugöffnungen oder Kanäle in dem Aufspanntisch einen Durchmesser bzw. Breite zwischen etwa 0,1 mm und etwa 2,0 mm auf, und vorzugsweise weisen die Ansaugöffnungen einen regelmäßigen Abstand entsprechend den aufzubringenden Haltekräften auf, so dass die Aufspannung der Rohschablone vorzugsweise eben erfolgt. Dies ermöglicht vorteilhaft, dass die Druckschablone durch Ansaugen mit einer vorteilhaften Ebenheit auf den Aufspanntisch aufgespannt werden kann. Weiterhin weist der Aufspanntisch bzw. die Platte aus ggf. porösem Stein eine Ebenheit im Wesentlichen von kleiner oder gleich 40 µm auf, vorzugsweise im Wesentlichen kleiner oder gleich 20 µm, insbesondere vorteilhaft vorzugsweise im Wesentlichen kleiner oder gleich 10 µm.

Erfindungsgemäß wird des Weiteren eine Druckschablone für den technischen Druck gemäß Anspruch 13 bereitgestellt.

Bevorzugte Ausgestaltungen der erfindungsgemäßen Druckschablone entsprechen Druckschablonen, die nach zumindest einem der vorstehend beschriebenen bevorzugten Herstellungsverfahren nach der vorliegenden Erfindung hergestellt sind. Diese werden hier im Einzelnen nicht erneut beschrieben, um Wiederholungen zu vermeiden, und es wird diesbezüglich auf die vorstehende Beschreibung der erfindungsgemäßen Verfahren und die entsprechenden beschriebenen Vorteile verwiesen.

### Kurzbeschreibung der Figuren

Fig. 1 zeigt beispielhaft eine schematische Darstellung einer Vorrichtung zur Durchführung eines Ausführungsbeispiels des Verfahrens zur Herstellung einer Druckschablone für den technischen Druck nach der vorliegenden Erfindung.
Fig. 2 zeigt beispielhaft eine schematische Darstellung einer Druckschablone nach einem Ausführungsbeispiel der vorliegenden Erfindung.
Fig. 3 zeigt beispielhaft eine schematische Darstellung eines Querschnitts einer Druckschablone nach einem Ausführungsbeispiel der vorliegenden Erfindung.

### Detaillierte Beschreibung der Figuren und bevorzugter

### Ausführungsbeispiele der vorliegenden Erfindung

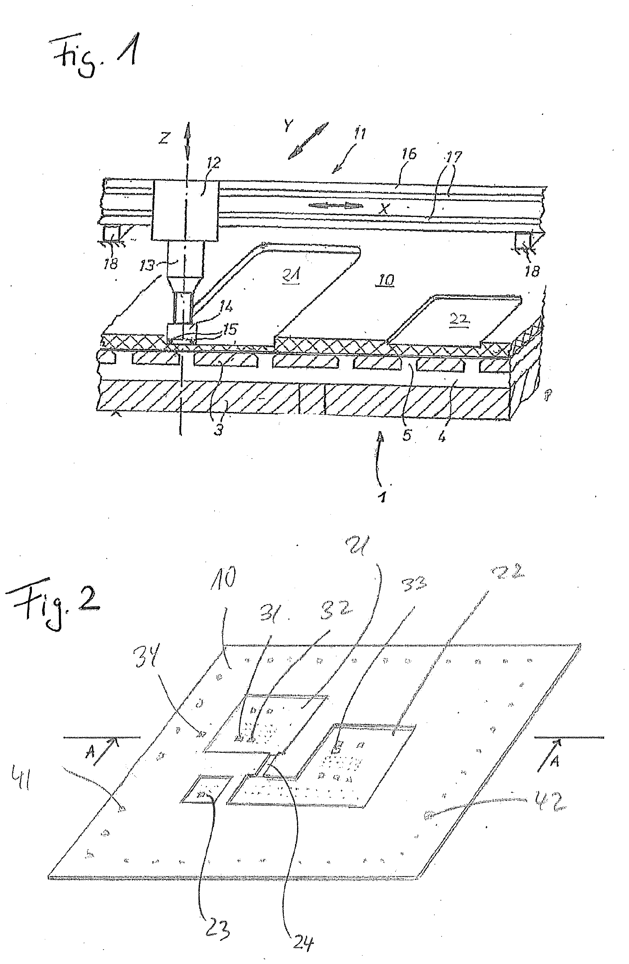

Fig. 1 zeigt beispielhaft eine schematische Darstellung einer Vorrichtung zur Durchführung eines Ausführungsbeispiels des Verfahrens zur Herstellung einer Druckschablone für den technischen Druck nach der vorliegenden Erfindung. Die dargestellte Vorrichtung umfasst einen großflächigen Aufspanntisch 1. Die Trag- bzw. Auflageplatte 3 des Aufspanntisches 1 ist als sog. Vakuumplatte ausgebildet und weist eine durchgehende Unterdruckkammer 4 sowie eine Vielzahl von oberseitigen Ansaugöffnungen 5 auf. Auf der Oberseite der Tragplatte liegt ein Rohblech 10 bzw. eine zu bearbeitende Rohschablone 10 auf, die durch Erzeugen eines Vakuums oder Unterdrucks in der Unterdruckkammer 4 über die Vielzahl von Saugöffnungen 5 an die Oberfläche der Tragplatte 3 eben angesaugt wird. Die Rohschablone 10 weist hierbei eine Schablonenstärke bzw. Blechstärke von etwa 20 µm bis 1000 µm auf.

Oberhalb des Tisches 1 ist eine Fräsvorrichtung 11, ggf. in Konsolbauweise angeordnet, die einen vertikalen Fräskopf 12 umfasst, der eine Arbeitsspindel 13 und einen in dieser eingespannten Stirnfräser 14 aufweist. Der Fräskopf 12 ist zumindest mittels drei Linearachsen in den drei räumlichen Raumrichtungen verfahrbar. Hierzu ist der Fräskopf 12 nach diesem , Ausführungsbeispiel an einer horizontalen Quertraverse 16 in zwei Führungsschienen 17 motorisch in der X-Koordinatenachse verfahrbar. Diese Quertraverse 16 wiederum ist z.B. endseitig auf zwei horizontalen Führungsschienen 18 abgestützt und auf diesen in Richtung der horizontalen Y-Koordinatenachse motorisch verfahrbar, so dass der Fräskopf 12 zur Steuerung des Stirnfräsers 15 gesteuerte Bewegungen in der horizontalen X-Y-Ebene ausführen kann. Die Steuerung des Fräskopfes erfolgt nach diesem Ausführungsbeispiel programmgesteuert, z.B. mittels Steuerung anhand eines NC-Programms bzw. CNC-Programms.

Wie in Fig. 1 beispielhaft gezeigt ist, sind in dem Rohblech 10, das vorzugsweise aus Edelstahl besteht, zwei Vertiefungen 21 und 22 durch Fräsen mittels des Stirnfräsers 15 herausgearbeitet, deren jeweils unterschiedliche Tiefe z.B. durch Einstellung des Vorschubs der Arbeitsspindel 13 in der vertikalen Z-Koordinatenachse oder auch durch Wiederholen von flächigen Fräsvorgängen gewählt werden kann.

Zum Herausarbeiten der Vertiefungen 21 und 22 wird die Rohschablone 10 auf die Tragplatte 3 aufgelegt und durch Anlegen eines Unterdrucks fixiert. Anschließend werden in vorgegebenen Bereichen der fixierten Rohschablone 10 die Vertiefungen 21 und 22 durch Fräsen bei Drehzahlen unter 10.000 min⁻¹ herausgearbeitet. Insbesondere werden in diesem Ausführungsbeispiel der vorliegenden Erfindung Drehzahlen zwischen 2.000 min⁻¹ und 6.000 min⁻¹ gewählt.

Durch Fräsen werden die Vertiefungen 21 und 22 in Bahnen mit bis zu 90% Überdeckungsgrad der Frässpuren herausgearbeitet, so dass die Oberfläche der Vertiefungen eine Oberflächenrauheit mit einem Rauheitswert Ra von mindestens 1 µm bis zu 12,5 µm aufweist. Insbesondere ist es in Bezug auf ein späteres Rakelverhalten bzw. Abrollverhalten der Lotpaste vor der Rakel vorteilhaft Oberflächen mit Rauheitswerten über 1 µm herauszuarbeiten. Hierzu kann die Oberfläche nach dem Fräsen weiterhin durch Schleifen und/oder Bürsten nachbearbeitet werden, um die Oberflächenrauheit noch weiter zu erhöhen.

Alternativ kann erst die Stufe erstellt werden und in einem weiteren Schritt des Herstellungsverfahrens wird die Rohschablone 10 in gewendeter Ausrichtung erneut auf die Tragplatte 3 aufgespannt, um in analoger Weise ggf. Vertiefungen auf der anderen Seite der Rohschablone 10 herauszuarbeiten, falls erforderlich.

Nach Herausarbeiten von einer oder mehrerer Vertiefungen 21 und 22 wird die Rohschablone 10 in gleicher oder gewendeter Ausrichtung in eine Vorrichtung zum Laserschneiden der Pad-Öffnungen eingesetzt, um in vorgegebenen Bereichen der Druckschablone die Pad-Öffnungen mit Hilfe eines Laserstrahls zu schneiden bzw. auszuschneiden. Insbesondere werden die Pad-Öffnungen nach den Vorgaben der zu bestückenden Leiterplatte bzw. der vorgesehenen Leiterplattenarchitektur in genauer vorgesehener Positionierung, Größe und Form ausgeschnitten.

Die Bereiche der Rohschablone 10, in denen Pad-Öffnungen herausgearbeitet werden sind insbesondere in den herausgearbeiteten Vertiefungen 21 und 22 vorgesehen, wobei die Tiefe der Vertiefungen bzw. die Reststärke der Schablone in den Bereichen der Vertiefungen derart herausgearbeitet werden, dass die herausgearbeiteten Pad-Öffnungen Lotpastendepots mit je nach Vorgabe unterschiedlichsten Lotpastendepotvolumina ausbilden.

Ein Lotpastendepotvolumen ergibt sich hierbei im Wesentlichen aus der Größe bzw. Form der jeweiligen Pad-Öffnungen und der Tiefe der Vertiefungen bzw. der Reststärke der Schablone 10 in dem Bereich um die jeweiligen Pad-Öffnungen. Insbesondere ermöglicht es das Verfahren nach der vorliegenden Erfindung präzise Lotpastendepots für Lotpastenvolumen von wenigen µm³ bis zu mehreren mm³ in einer Druckschablone herauszuarbeiten.

Da derartige Vorrichtungen zum vorstehend beschriebenen Laserschneiden von derartigen Pad-Öffnungen dem Stand der Technik bekannt sind, wird hier auf eine detaillierte Beschreibung des Ausschneidens der Pad-Öffungen mittels eines Laserstrahls verzichtet.

Fig. 2 zeigt beispielhaft eine schematische Darstellung einer Druckschablone 10 nach einem Ausführungsbeispiel der vorliegenden Erfindung. Die Druckschablone ist hierbei beispielhaft eine sog. Lochrandschablone, d.h. eine Druckschablone, die aus nur einem Rohblech gefertigt ist und zumindest zwei gegenüberliegenden Rändern der Druckschablone 10, hier beispielhaft an vier Rändern der Druckschablone 10, einen sog. Lochrand zum Einspannen der Druckschablone 10 in ein Einspannsystem für Druckschablonen aufweist.

Beispielhaft umfasst der Lochrand in gleichmäßigen Abständen verteilte Einspannöffnungen, in Fig. 2 unter Anderen beispielhaft die Einspannöffnung 41 auf der linken Seite und die Einspannöffnung 42 auf der rechten Seite, mittels derer die Druckschablone 10 in ein Schnellspannsystem oder einen Spannrahmen für Lochrandschablonen eingespannt werden kann. Die genaue Anordnung und Form der Einspannöffnungen wird hierbei an ein jeweiliges Einspannsystem angepasst, für welches die Druckschablone 10 vorgesehen ist.

Insbesondere bietet die vorliegende Erfindung die vorteilhafte Möglichkeit bei der Herstellung einer Druckschablone 10 mit einem vorgesehenen Lochrand die Einspannöffnungen 41 und 42 fräsend herauszuarbeiten. Somit können die Einspannöffnungen 41 und 42 und die Vertiefungen 21und 22 vorteilhaft in einem Arbeitsgang an der Fräsvorrichtung 11 herausgearbeitet werden, insbesondere ggf. ohne eine Änderung der Auflagepositionierung der Rohschablone 10 auf dem Aufspanntisch 1.

Jedoch ist die vorliegende Erfindung nicht auf die Herstellung derartiger Lochrandschablonen beschränkt. Vielmehr können ebenfalls Druckschablonen ohne Lochrand gefertigt werden, die dazu geeignet sind mittels anderer Einspannsysteme bzw. Einspannarten für den technischen Druck eingespannt zu werden. So können Druckschablonen ohne Lochrand z.B. auf ein in einen formsteifen Rahmen eingespannten Siebgewebe mit einem mittigen Ausschnitt für die Aufnahme der Druckschablone an den Rändern der Druckschablone aufgeklebt, aufgeschweißt oder andersartig befestigt werden. Insbesondere ist es mit dem erfindungsgemäßen Verfahren möglich, den für den Druck relevanten Innenbereich der Druckschablone unabhängig von Erfordernissen eines Einspannsystems zu bearbeiten, um die Pad-Öffnungen und eine oder mehrere Vertiefungen bzw. Stufen herauszuarbeiten.

Die in Fig. 2 dargestellte Druckschablone weist weiterhin Vertiefungen 21, 22 und 23 auf, die nach dem vorstehend beschriebenen Verfahren fräsend aus der Rohschablone 10 herausgearbeitet wurden. Die Vertiefungen sind hierbei in genauer vorgesehener Positionierung, Größe, Form und Tiefe herausgearbeitet.

Im Innenbereich der Vertiefungen 21, 22 und 23 sind jeweils eine Mehrzahl von Pad-Öffnungen 31, 32 und 33 in genauer Positionierung, Größe und Form in Abhängigkeit der vorgesehenen Leiterplattenarchitektur, d.h. in Abhängigkeit der vorgesehenen Lage, Art und Positionierung der auf der Leiterplatte zu bestückenden bzw. aufzubringenden elektronischen Bauelemente durch Laserschneiden herausgearbeitet, wie vorstehend beschrieben. Eine weitere Pad-Öffnung 34 ist beispielhaft in einem Bereich der Druckschablone 10 herausgearbeitet, in dem keine Vertiefung herausgearbeitet ist.

Nach dem erfindungsgemäßen Verfahren ist es weiterhin möglich, Vertiefungen beliebiger Form herauszuarbeiten. Insbesondere ist es möglich, Vertiefungen zu verbinden. So ist in Fig. 2 beispielhaft dargestellt, dass die Vertiefungen 21 und 22 durch eine Vertiefung 24 "brückenartig" verbunden sind.

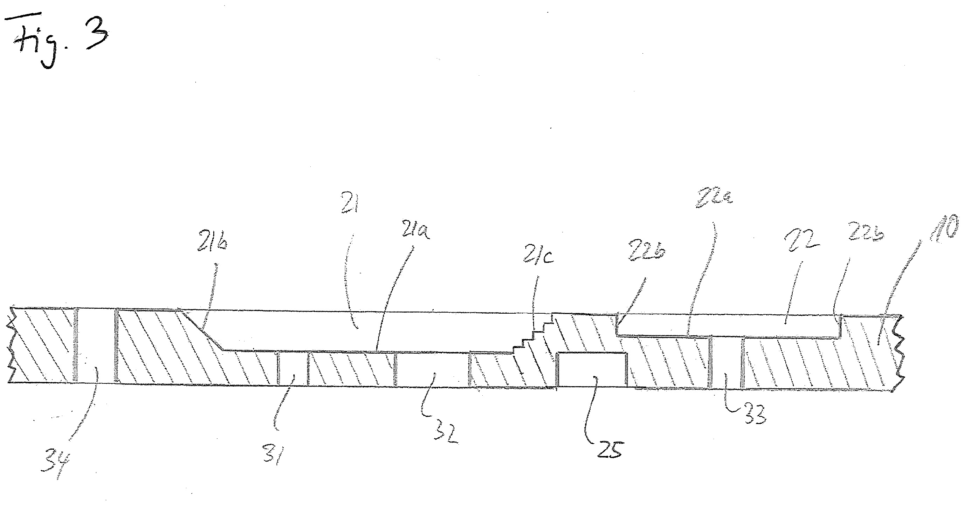

Fig. 3 zeigt beispielhaft eine schematische Darstellung eines Querschnitts des Innenbereichs einer Druckschablone 10 nach einem Ausführungsbeispiel der vorliegenden Erfindung. Die Schnittlinie des Querschnitts in Fig. 3 entspricht der Schnittlinie A-A, die in Fig. 2 dargestellt ist. In der Druckschablone 10 sind Vertiefungen 21 und 22 nach dem vorstehend beschriebenen Verfahren der vorliegenden Erfindung herausgearbeitet. Des Weiteren umfasst die Druckschablone 10 im Innenbereich der Vertiefung 21 die Pad-Öffnungen 31 und 32, und im Innenbereich der Vertiefung 22 die Pad-Öffnung 33. Auch in einem Bereich der Druckschablone 10, in dem keine Vertiefung herausgearbeitet ist, ist beispielhaft eine Pad-Öffnung 34 mittels eines Laserstrahls ausgeschnitten. Auf der Leiterplattenseite umfasst die Druckschablone weiterhin eine Vertiefung 25.

Die Vertiefungen 21 und 22 sind jeweils mit unterschiedlicher Tiefe aus der Druckschablone 10 herausgearbeitet, wobei die Oberflächen 21a und 22a der Vertiefungen 21 und 22 regelmäßige Frässpuren aufweisen (nicht gezeigt) und insbesondere einen Rauheitswert Ra von 0.5 µm bis 12,5 µm aufweisen.

Der Rand 21b der Vertiefung 21 ist rampenförmig ausgebildet, so dass die Rakel bei der Rakelbewegung vorteilhaft an diesen ausgeformten rampenförmigen Rändern 21b der Vertiefung 21 auf- bzw. abklettern kann, wodurch eine besonders gleichmäßige Rakelbewegung ermöglicht ist. Der Rand 21c der Vertiefung 21 ist beispielhaft in mehreren Stufen ausgebildet, wodurch ebenfalls ein auf- bzw. abklettern des Rakels ermöglicht wird.

Des Weiteren bleiben bei der Rakelbewegung vorteilhaft höchstens geringe Mengen von Lotpaste bzw. keine Lotpastenreste nach der Rakelbewegung an den Rändern 21b und 21c aufgrund dieser rampenförmigen bzw. stufenförmigen Ausbildung haften. Durch die hohe Präzision des fräsenden Herausarbeitens der Vertiefung 21 kann die rampenförmige Ausformung des Randes 21b präzise in einer gewünschten Ausformung mit einem vorteilhaften Winkel herausgearbeitet werden.

Zudem ist es jedoch ebenfalls möglich, rechteckige Stufen herauszuarbeiten. So weist die Vertiefung 22 z.B. an ihren Rändern 22b beispielhaft senkrechte bzw. rechtwinklige Stufen auf.

Weiterhin ist in Fig. 3 beispielhaft gezeigt, dass die Pad-Öffnungen 31, 32, 33 und 34 in unterschiedlichen Größen und Höhen herausgearbeitet bzw. herausgeschnitten sind. Somit ergeben sich im Innenbereich der Pad-Öffnungen 31, 32, 33 und 34 unterschiedliche Lotpastendepots mit insbesondere unterschiedlichen Lotpastendepothöhen, die im Wesentlichen jeweils durch die Reststärke der Schablone 10 in dem Bereich um die jeweiligen Pad-Öffnungen 31, 32 und 33 bzw. durch die Schablonenstärke selbst für die Pad-Öffnung 34 gegeben sind. Somit können die Pad-Öffnungen 31, 32 und 33 in Abhängigkeit der Tiefe und Größe bzw. Öffnungsfläche der Pad-Öffnungen unterschiedliche Lotpastendepotvolumina aufweisen. Aus Fig. 3 wird hierbei ersichtlich, dass die Lotpastendepotvolumina der jeweiligen Pad-Öffnungen 31, 32, 33 und 34 jeweils durch die Depothöhe bzw. Reststärke der Schablone 10 und der Größe der Pad-Öffnungen 31, 32, 33 und 34 gegeben sind.

Durch das vorstehend beschriebene erfindungsgemäße Ausführungsbeispiel eines Verfahrens zum Herstellen von Druckschablonen für den technischen Druck, insbesondere den technischen Leiterplattendruck, wird ein Verfahren und entsprechende erfindungsgemäße Druckschablonen bereitgestellt, derart, dass ein Herausarbeiten von Vertiefungen auf der Druckschablone bei hoher Genauigkeit und Flexibilität bezüglich der Größe, Tiefe, Form und Positionierung der Vertiefungen ermöglicht ist, und die Druckschablone des Weiteren ein präzises gleichmäßiges Druckverhalten bzw. Rakelverhalten beim Aufbringen der Lotpaste mittels der Rakel aufweist, insbesondere mit präzise aufgebrachten Lotpastenvolumina. Durch die vorteilhaften Rauheitswerte der Oberflächen der herausgearbeiteten Vertiefungen wird insbesondere ein verbessertes Abrollverhalten der Lotpaste vor der Rakel bei der Rakelbewegung ermöglicht, so dass die Lotpaste vorteilhaft gleichmäßig und vollständig in die Pad-Öffnungen eingebracht werden kann, wodurch die Genauigkeit bezüglich des Lotpastenvolumens in der Pad-Öffnung entsprechend eines Sollwerts verbessert werden kann.

## Patentansprüche

1. Verfahren zum Herstellen einer Druckschablone für den technischen Druck, umfassend die Verfahrensschritte:
- Aufspannen einer Rohschablone (10) einer Druckschablone (10) auf einer ebenen Tragplatte (3) mit Ansaugöffnungen (5) oder einer ebenen Tragplatte aus porösem Material, insbesondere aus Stein oder Metall, zum ebenen Ansaugen der Rohschablone (10) durch Unterdruck,
- Ausschneiden von einer Mehrzahl von Pad-Öffnungen (31, 32, 33, 34) aus der Druckschablone (10) in vorgegebener genauer Positionierung, Größe und Form mittels eines Laserstrahls, und
- Herausarbeiten von einer oder mehrerer ebenen Vertiefungen (21, 22, 23, 24, 25) in vorgegebener Positionierung, Form, Größe und/oder Tiefe aus der aufgespannten Druckschablone (10) auf mindestens einer Seite der Druckschablone (10) durch Fräsen mittels eines Fräswerkzeugs (15),
**dadurch gekennzeichnet, dass**
das Herausarbeiten von einer oder mehrerer ebenen Vertiefungen (21, 22, 23, 24, 25) durch Fräsen mittels des Fräswerkzeugs (15) bei Drehzahlen unter 10.000 min⁻¹ durchgeführt wird, und
die Oberfläche (21a, 22a) der durch Fräsen herausgearbeiteten Vertiefungen (21, 22, 23, 24, 25) eine Oberflächenrauheit mit einem Rauheitswert Ra in einem Bereich von 1 µm bis 12,5 µm aufweist.

2. Verfahren nach Anspruch 1, **dadurch gekennzeichnet, dass**
in dem Schritt Herausarbeiten der einen oder mehreren Vertiefungen (21, 22, 23, 24, 25) die eine oder mehreren Vertiefungen (21, 22, 23, 24, 25) durch Fräsen mittels eines Fräswerkzeugs bei Drehzahlen zwischen 2.000 und 10.000 min⁻¹, insbesondere zwischen 2.000 und 6.000 min⁻¹, herausgearbeitet werden.

3. Verfahren nach Anspruch 1 oder 2, **dadurch gekennzeichnet, dass**
die Rohschablone (10) aus Edelstahl ist; und/oder die Rohschablone (10) einen Härtegrad bis 560HV aufweist.

4. Verfahren nach zumindest einem der Ansprüche 1 bis 3, **dadurch gekennzeichnet, dass**
die eine oder mehreren Vertiefungen (21, 22, 23, 24, 25) derart herausgearbeitet werden, dass die Druckschablone (10) in der einen oder mehreren Vertiefungen (21, 22, 23, 24, 25) eine Reststärke größer oder gleich 10 µm aufweist.

5. Verfahren nach zumindest einem der Ansprüche 1 bis 4, **dadurch gekennzeichnet, dass**
die Rohschablone (10) eine Schablonenstärke von 20 µm bis 1000 µm aufweist.

6. Verfahren nach zumindest einem der Ansprüche 1 bis 5, **dadurch gekennzeichnet, dass**
die eine oder mehreren Vertiefungen (21, 22, 23, 24, 25) derart durch Fräsen herausgearbeitet werden, dass ein oder mehrere Ränder (21c, 22b) der einen oder mehreren Vertiefungen (21, 22, 23, 24, 25) als eine oder mehrere Stufen ausgebildet werden; und/oder
die eine oder mehreren Vertiefungen (21, 22, 23, 24, 25) derart durch Fräsen herausgearbeitet werden, dass ein oder mehrere Ränder (21b) der einen oder mehreren Vertiefungen (21, 22, 23, 24, 25) rampenförmig ausgebildet sind.

7. Verfahren nach zumindest einem der Ansprüche 1 bis 6, **dadurch gekennzeichnet, dass**
der Abstand zwischen den Rändern (21b, 21b, 22b) von zwei herausgearbeiteten Vertiefungen (21, 22, 23, 24, 25) größer oder gleich 5 µm ist.

8. Verfahren nach zumindest einem der Ansprüche 1 bis 7, **dadurch gekennzeichnet, dass**
das Verfahren weiterhin den Schritt des Glättens einer Innenwandung einer der Mehrzahl von Pad-Öffnungen (31, 32, 33, 34) umfasst, wobei das Glätten einer Innenwandung einer Pad-Öffnung (31, 32, 33, 34) mittels eines elektrochemischen Abtragungsverfahrens durchgeführt wird, insbesondere mittels eines elektrochemischen Polierverfahrens.

9. Verfahren nach zumindest einem der Ansprüche 1 bis 8, **dadurch gekennzeichnet, dass**
die eine oder mehrere Vertiefungen (25) zumindest auf der Leiterplattenseite der Druckschablone (10) herausgearbeitet werden, wobei die eine oder mehrere Vertiefungen (25) auf der Leiterplattenseite in Abhängigkeit einer Positionierung, Größe, Höhe und/oder Form von Durchkontaktierungen auf der Leiterplatte herausgearbeitet werden.

10. Verfahren nach zumindest einem der Ansprüche 1 bis 9, **dadurch gekennzeichnet, dass**
die Oberfläche (21a, 22a) der einen oder mehreren Vertiefungen (21, 22, 23, 24, 25) regelmäßige Frässpuren aufweist, wobei das Fräswerkzeug (15) insbesondere mit Vorschub bei einem Überdeckungsgrad der Frässpuren von bis zu 90% betrieben wird.

11. Verfahren nach zumindest einem der Ansprüche 1 bis 10, **dadurch gekennzeichnet, dass**
die Oberfläche (21a, 22a) der herausgearbeiteten Vertiefungen (21, 22, 23, 24, 25) eine Ebenheit unter 40 µm aufweist; und/oder
die Tragplatte (3) eine Ebenheit unter 40 µm aufweist.

12. Verfahren nach zumindest einem der Ansprüche 1 bis 11, **dadurch gekennzeichnet, dass**
die Tragplatte (3) einen Welligkeitswert unter 5 µm aufweist und die Ansaugöffnungen (5) einen Durchmesser zwischen 0,1 mm und 2,0 mm, und einen regelmäßigen Abstand entsprechend den aufzubringenden Haltekräften aufweisen, so dass die Aufspannung der Rohschablone (10) eben erfolgt.

13. Druckschablone für den technischen Druck, die mittels eines Verfahrens gemäß zumindest einem der vorstehenden Ansprüche hergestellt ist, wobei die Druckschablone mehrere Pad-Öffnungen und eine oder mehrere ebene, durch Fräsen herausgearbeiteten Vertiefungen auf mindestens einer Seite der Druckschablone umfasst, und wobei die Oberfläche der durch Fräsen herausgearbeiteten Vertiefungen regelmäßige Frässpuren und eine Oberflächenrauheit mit einem Rauheitswert Ra von 1 µm bis 12,5 µm aufweist.

## Claims

1. A method for producing a printing stencil for technical printing, comprising the following method steps:
- clamping a blank stencil (10) of a printing stencil (10) on a planar support plane (3) with suction ports (5) or a planar support plane of a porous material, especially of stone or metal, for planar suction of the blank stencil (10) by negative pressure,
- cutting out a plurality of pad openings (31, 32, 33, 34) from said printing stencil (10) in predetermined exact positioning, size, and shape by means of a laser beam, and
- carving out one or more planar indentations (21, 22, 23, 24, 25) in predetermined positioning, shape, size, and/or depth from the clamped printing stencil (10) at least on one side of the printing stencil (10) by milling by means of a milling tool (15),
**characterized in that**
the carving out one or more planar indentations (21, 22, 23, 24, 25) by milling by means of the milling tool (15) is performed at rotational speeds below 10,000 min⁻¹, and
the surface (21a, 22a) of the indentations (21, 22, 23, 24, 25) carved out by milling has a surface roughness with a roughness value Ra of between 1 µm and 12.5 µm.

2. A method according to claim 1, **characterized in that**
in the step of carving out said one or more indentations (21, 22, 23, 24, 25), said one or more indentations (21, 22, 23, 24, 25) are carved out by milling by means of a milling tool at rotational speeds between 2,000 and 10,000 min⁻¹, especially between 2,000 and 6,000 min⁻¹.

3. A method according to claim 1 or 2, **characterized in that**
said blank stencil (10) is of stainless steel; and/or said blank stencil (10) has a hardness level up to 560 HV.

4. A method according to at least one of the claims 1 to 3, **characterized in that**
said one or more indentations (21, 22, 23, 24, 25) are carved out such that said printing stencil (10) has a residual thickness equal to or larger than 10 µm in said one or more indentations (21, 22, 23, 24, 25).

5. A method according to at least one of the claims 1 to 4, **characterized in that**
said blank stencil (10) has a stencil thickness of 20 µm to 1000 µm.

6. A method according to at least one of the claims 1 to 5, **characterized in that**
said one or more indentations (21, 22, 23, 24, 25) are carved out by milling such that one or more rims (21c, 22b) of said one or more indentations (21, 22, 23, 24, 25) are formed as one or more steps; and/or
said one or more indentations (21, 22, 23, 24, 25) are carved out by milling such that one or more rims (21b) of said one or more indentations (21, 22, 23, 24, 25) are formed in a ramp shape.

7. A method according to at least one of the claims 1 to 6, **characterized in that**
the distance between said rims (21b, 21c, 22b) of two indentations (21, 22, 23, 24, 25) carved out is larger than or equal to 5 µm.

8. A method according to at least one of the claims 1 to 7, **characterized in that**
the method further comprises the step of smoothing an inner wall of a plurality of pad openings (31, 32, 33, 34), wherein the smoothing of an inner wall of a pad opening (31, 32, 33, 34) is carried out by means of an electrochemical ablation method, especially by means of an electrochemical polishing method.

9. A method according to at least one of the claims 1 to 8, **characterized in that**
said one or more indentations (25) are carved out at least on the circuit board side of the printing stencil (10), wherein the one or more indentations (25) on said circuit board side are carved out as a function of a positioning, size, height, and/or shape of vias on said circuit board.

10. A method according to at least one of the claims 1 to 9, **characterized in that**
the surface (21a, 22a) of said one or more indentations (21, 22, 23, 24, 25) has regular milling traces, wherein said milling tool (15) is especially operated with feed at a coverage ratio of the milling traces of up to 90 %.

11. A method according to at least one of the claims 1 to 10, **characterized in that**
the surface (21a, 22a) of said carved-out indentations (21, 22, 23, 24, 25) has a flatness below 40 µm; and/or
said support plane (3) has a flatness below 40 µm.

12. A method according to at least one of the claims 1 to 11, **characterized in that**
said support plane (3) has a ripple value below 5 µm and said suction ports (5) have a diameter between 0.1 mm and 2,0 mm and a regular distance corresponding to the retention force to be applied, such that the clamping of the blank stencil (10) occurs planarly.

13. A printing stencil for technical printing, produced by means of a method according to at least one of the preceding claims, wherein said printing stencil comprises multiple pad openings and one or more planar indentations carved out by milling on at least one side of said printing stencil, and wherein the surface of said indentations carved out by milling has regular milling traces and a surface roughness with a roughness value Ra of between 1 µm and 12.5 µm.

## Revendications

1. Procédé de réalisation d'un pochoir d'impression pour l'impression technique, comprenant les étapes consistant à :
- serrer un pochoir brut (10) d'un pochoir d'impression (10) sur une plaque de support plane (3) ayant des ouvertures d'aspiration (5) ou sur une plaque de support plane en matériau poreux, en particulier en pierre ou en métal, pour l'aspiration à plat du pochoir brut (10) par dépression,
- découper une pluralité d'ouvertures de tampon (31, 32, 33, 34) dans le pochoir d'impression (10) selon un positionnement, une taille et une forme précis prédéterminés, au moyen d'un faisceau laser, et
- usiner un ou plusieurs renfoncements plans (21, 22, 23, 24, 25) de positionnement, forme, taille et/ou profondeur prédéterminés dans le pochoir d'impression (10) serré, sur au moins un côté du pochoir d'impression (10), par fraisage au moyen d'un outil de fraisage (15),
**caractérisé en ce que**
l'usinage d'un ou de plusieurs renfoncements plans (21, 22, 23, 24, 25) s'effectue par fraisage au moyen d'un outil de fraisage (15) à des vitesses de rotation inférieures à 10.000 min⁻¹, et
la surface (21a, 22a) des renfoncements (21, 22, 23, 24, 25) usinés par fraisage présente une rugosité de surface ayant une valeur de rugosité Ra dans une plage de 1 µm à 12,5 µm.

2. Procédé selon la revendication 1, **caractérisé en ce que**
dans l'étape de l'usinage d'un ou de plusieurs renfoncements (21, 22, 23, 24, 25), ledit renfoncement ou lesdits plusieurs renfoncements (21, 22, 23, 24, 25) sont usinés par fraisage au moyen d'un outil de fraisage à des vitesses de rotation entre 2.000 et 10.000 min⁻¹, en particulier entre 2.000 et 6.000 min⁻¹.

3. Procédé selon la revendication 1 ou 2, **caractérisé en ce que**
le pochoir brut (10) est en acier inoxydable ; et/ou le pochoir brut (10) présente un degré de dureté allant jusqu'à 560 HV.

4. Procédé selon l'une au moins des revendications 1 à 3, **caractérisé en ce que**
le ou lesdits plusieurs renfoncements (21, 22, 23, 24, 25) sont usinés de telle sorte que le pochoir d'impression (10) présente une épaisseur résiduelle supérieure ou égale à 10 µm dans ledit ou lesdits plusieurs renfoncements (21, 22, 23, 24, 25).

5. Procédé selon l'une au moins des revendications 1 à 4, **caractérisé en ce que**
le pochoir brut (10) présente une épaisseur de pochoir de 20 µm à 1000 µm.

6. Procédé selon l'une au moins des revendications 1 à 5, **caractérisé en ce que**
ledit ou lesdits plusieurs renfoncements (21, 22, 23, 24, 25) sont usinés par fraisage de telle sorte qu'un ou plusieurs bords (21c, 22b) dudit ou desdits plusieurs renfoncements (21, 22, 23, 24, 25) se présentent sous la forme d'un ou de plusieurs étages; et/ou
ledit ou lesdits plusieurs renfoncements (21, 22, 23, 24, 25) sont usinés par fraisage de telle sorte qu'un ou plusieurs bords (21b) dudit ou desdits plusieurs renfoncements (21, 22, 23, 24, 25) se présentent sous forme de rampes.

7. Procédé selon l'une au moins des revendications 1 à 6, **caractérisé en ce que**
la distance entre les bords (21b, 21b, 22b) de deux renfoncements usinés (21, 22, 23, 24, 25) est supérieure ou égale à 5 µm.

8. Procédé selon l'une au moins des revendications 1 à 7, **caractérisé en ce que**
le procédé comprend en outre l'étape de lissage d'une paroi intérieure de l'une de la pluralité d'ouvertures de tampon (31, 32, 33, 34), le lissage d'une paroi intérieure d'une ouverture de tampon (31, 32, 33, 34) étant effectué au moyen d'un procédé d'enlèvement électrochimique, en particulier au moyen d'un procédé de polissage électrochimique.

9. Procédé selon l'une au moins des revendications 1 à 8, **caractérisé en ce que**
ledit ou lesdits plusieurs renfoncements (25) sont usinés au moins sur le côté carte de circuit imprimé du pochoir d'impression (10), ledit ou lesdits plusieurs renfoncements (25) sur le côté carte de circuit imprimé étant usinés en fonction d'un positionnement, d'une taille, d'une hauteur et/ou d'une forme de vias sur la carte de circuit imprimé.

10. Procédé selon l'une au moins des revendications 1 à 9, **caractérisé en ce que**
la surface (21a, 22a) dudit ou desdits plusieurs renfoncements (21, 22, 23, 24, 25) présente des pistes de fraisage régulières, l'outil de fraisage (15) étant actionné en particulier avec une avance à un degré de chevauchement des pistes de fraisage allant jusqu'à 90%.

11. Procédé selon l'une au moins des revendications 1 à 10, **caractérisé en ce que**
la surface (21a, 22a) des renfoncements usinés (21, 22, 23, 24, 25) présente une planéité inférieure à 40 µm ; et/ou
la plaque de support (3) présente une planéité inférieure à 40 µm.

12. Procédé selon l'une au moins des revendications 1 à 11, **caractérisé en ce que**
la plaque de support (3) présente une valeur d'ondulation inférieure à 5 µm et les ouvertures d'aspiration (5) ont un diamètre compris entre 0,1 mm et 2,0 mm, et une distance régulière en correspondance des forces de maintien à appliquer, de sorte que le pochoir brut (10) est serré à plat.

13. Pochoir d'impression pour l'impression technique, réalisé par un procédé selon l'une au moins des revendications précédentes, le pochoir d'impression comprenant plusieurs ouvertures de tampon et un ou plusieurs renfoncements plans usinés par fraisage sur au moins un côté du pochoir d'impression, la surface des renfoncements usinés par fraisage présentant des pistes de fraisage régulières et une rugosité de surface ayant une valeur de rugosité Ra de 1 µm à 12,5 µm.
